# EUROPEAN PATENT APPLICATION

(11) **EP 2 506 297 A1**
(43) Date of publication of application: **03.10.2012**
(21) Application number: 11160295.9
(22) Date of filing: 29.03.2011
(51) Int. Cl.: H01L 21/8249, H01L 27/06, H01L 21/331

(54) **Bi-CMOS Device and Method**

(71) Applicant: NXP B.V., 5656 AG Eindhoven (NL)
(72) Inventor: Donkers, Johan, Redhill, Surrey RH1 1DL (GB); Mertens, Hans, Redhill, Surrey RH1 1DL (GB); Vanhoucke, tony, Redhill, Surrey RH1 1DL (GB); Duriez, Blandine, Redhill, Surrey RH1 1DL (GB); Gridelet, Evelyne, Redhill, Surrey RH1 1DL (GB)
(74) Representative: Williamson, Paul Lewis

(57) **Abstract**

A method of manufacturing a bipolar transistor and a CMOS transistor forms a bipolar transistor with a sacrificial spacer (26) in a window (20) formed in a gate stack (14,12), forms an emitter (28) in the centre of the spacer (26) and etches back. The sacricial spacer (26) is removed by etching and gate stack (14,12) is then removed in the step that patterns the gate of the CMOS transistor. The step of forming the low doped drain in the CMOS transistor may be used to provide additional doping in the bipolar transistor under a further spacer.

## Description

The invention relates to a Bi-CMOS architecture, including a BiCMOS device and method of making it.

Semiconductor devices combining complementary metal oxide semiconductor (CMOS) devices and bipolar transistors, known as Bi-CMOS, are an active area of device research.

For low cost processing, it is generally desirable to use an existing CMOS process and adapt it to form bipolar transistors as well. This often results in some compromises in the process. While high performance dedicated Bi-CMOS processes do exist, these are in general high cost processes which are not suitable in all applications.

An existing relatively low cost process is described in particular in US 2005/0218399 which forms the basis for a process to form bipolar transistors that has been demonstrated in a 0.14 µm CMOS baseline process. Figure 1 shows a bipolar transistor that is fabricated as illustrated in Figure 8 of US 2005/0218399. In particular, a buried collector 102 is surrounded by an isolation structure 104. A SiGe base 106 is formed on the collector in a well in a CMOS gate structure 108 made up of gate insulator 110, gate 112 which in the bipolar structure acts as a base connector 112 and insulator 114. An internal polysilicon layer 116 connects the base 106 to the base connector 112. An emitter 118 is formed on the base 106 within an insulator 120. An emitter contact 122 connects to the emitter 118.

Such bipolar transistors are generally formed before the CMOS process is completed, and in particular before the CMOS sidewall spacers 124 are formed. The formation of CMOS sidewall spacers 124 forms spacers of various widths depending on step height. The CMOS sidewall spacers 124 have some useful function on the outer edge of the base connector 112 but not for example on the edge of the emitter contact 122.

The insulator 120 forms an internal spacer and it would be desirable to shape this optimally, for example by making it relatively narrow at the bottom to allow a good contact to the base but thick at the top to increase the base-emitter resistance. However, it is difficult to form an insulator 120 to the correct shape in a conventional CMOS process.

Accordingly, there is a need for an improved process to form a bipolar transistor in a conventional CMOS process to form a low-cost Bi-CMOS device.

According to the invention there is provided a method of forming a bipolar transistor according to claim 1.

The method is an alternative low-cost bipolar transistor process that is compatible with CMOS processing. The CMOS spacers that are present in the CMOS baseline process are used in the process instead of being artefacts to be optimised or removed. The method maintains the strong point of the original low cost, or low complexity bipolar process of US 2005/0218399 and maintains full compatibility with a baseline CMOS process.

The method is compatible with the baseline CMOS process because the bipolar processing does not affect the baseline CMOS process. All critical MOS related process steps, i.e. source-drain formation and threshold voltage adjust implantations are performed after the bipolar transistor fabrication.

The method may further include forming a low doped region before the step of forming oxide spacers in the CMOS process. This may form a low doped region in the base layer except under the emitter to enhance the conduction in the base layer. In particular, this step may use the conventional implant used to form a low doped drain in the CMOS process. In the bipolar transistor thus formed, this targets lower base resistance, which may improve important parameters of the device such as the maximum oscillation frequency fmax and the minimum noise figure NFmin.

The method of forming the base may include depositing a layer in a base window formed in a gate stack layer to form a crystalline base region above a buried collector and a polycrystalline base connection region above the shallow trench isolation regions and on the sidewalls of the base window.

Embodiments of the invention will now be described, purely by way of example, with reference to the accompanying drawings, in which:
Figure 1 shows a prior art bipolar transistor manufactured in CMOS;
Figures 2 to 7 show the steps in a manufacturing process according to an embodiment of the invention;
Figure 8 shows a detail of the base layer used in the embodiment of Figures 2 to 7; and
Figure 9 shows a doping step that may be used in an embodiment of the invention.
The drawings are schematic and not to scale.

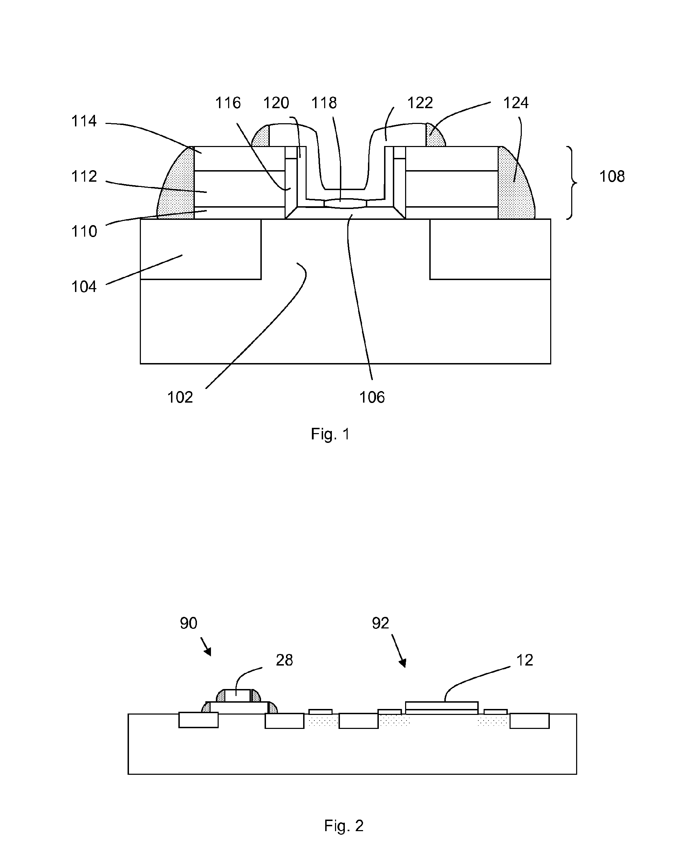

Referring to Figure 2, a semiconductor substrate 2 is processed using the steps of conventional CMOS processing. In the following description, various process steps will be used to describe the relevant CMOS processing step. For example, the step described as "forming a gate oxide layer" describes the step which forms the gate oxide in the CMOS process, even though the step is used for a different purpose when forming the bipolar transistor.

The substrate in the embodiment is processed to form both a heterostructure bipolar transistor 90 (HBT) and a CMOS transistor 92. Some elements of these are shown in Figure 2 and discussed below in more detail.

Those skilled in the art will realise that many transistors may be formed together with other structures such as interconnects, contacts, resistors and others to form an integrated circuit. Some steps, for example the back end processing to form interconnects, are conventional and such conventional steps will not be further described.

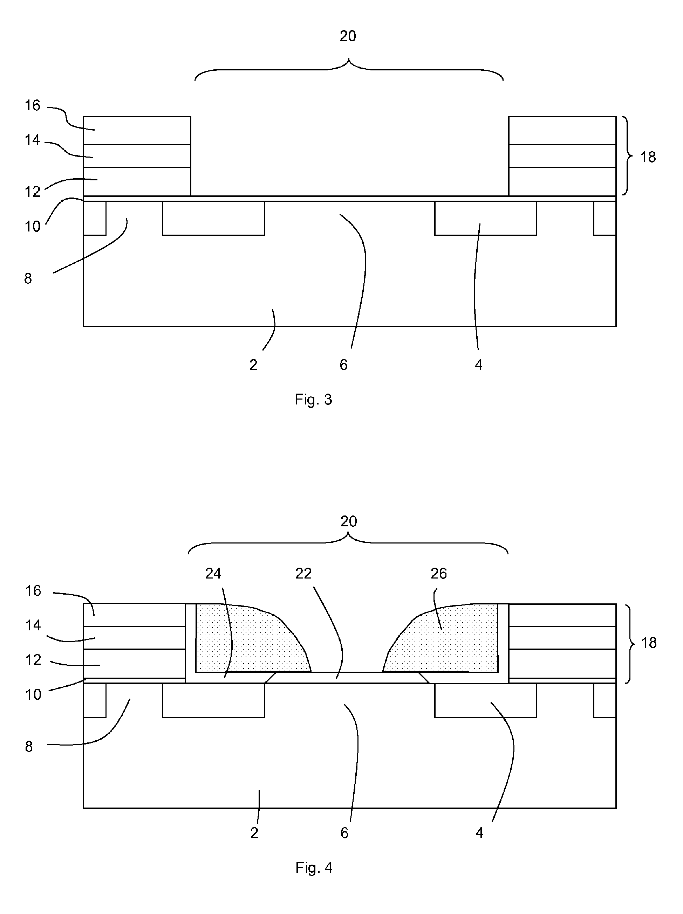

Referring to Figure 3, shallow trench isolation, STI, structures 4 are formed in the substrate which define a collector region 6 and a collector contact region 8 between the STI structures 4.

A gate oxide layer 10 is then formed. As indicated above, this is the layer used to form the gate oxide in the CMOS process to form CMOS transistor 92 but does not in fact function as a gate oxide in the bipolar transistor.

Then a stack 18 is formed again using CMOS processes. In particular, in the CMOS process a gate stack 18 is formed that is used in the CMOS transistor 92 to form the gate of the CMOS transistor 92.

The stack 18 as formed in the process consists of a polysilicon gate 12, followed by 165nm of a chemical mechanical polishing, CMP, etch stop layer 14 of silicon nitride and a polysilicon layer 16 on top. The etch stop layer 14 is used in the planarization process. The polysilicon layer 16 improves the base-epi quality and hence is referred to a defect getter layer 16. In this embodiment, the polysilicon layer 16 is doped later during the corresponding doping step in the conventional CMOS processing flow, after removing etch stop layer 14.

To be able to create wide spacers 26 later in the process, a sufficient defect getter layer 16 thickness is required. Spacer width is namely determined mainly by two things: the step height and the deposited thickness of the material that is used to create the spacer. The thickness of the stack 18 and the layers in the stack is therefore adjusted to obtain the required spacer width.

The conventional baseline CMOS processing flow is interrupted at this point to form the bipolar transistor 90.

A bipolar base window 20 is patterned and formed in the stack 18 down to the gate oxide 10 using a dry etch which stops on gate oxide 10 . A schematic cross-section after this patterning step is shown in Figure 3.

Compared to the processing described in US2005/0218399 the overlap between the base window and the collector region 6 is increased. This improves manufacturability because the amount of open area in the base window 20 is increased, which makes the mask used to pattern the window less expensive and end point detection during dry etch easier.

A wet etch is then carried out that removes the gate oxide 10 in the base window 20.

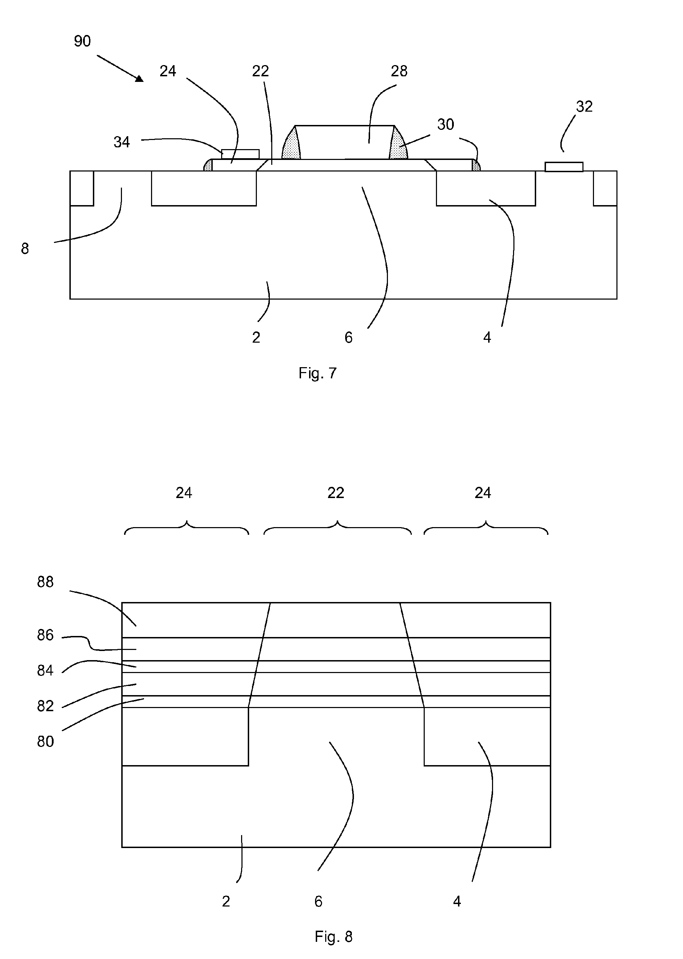

Base-epitaxy is then performed to grow the SiGe:C base layer 22. Although shown as a single base layer 22, the base layer 22 may in fact be formed as multiple layers as illustrated in Figure 8. Firstly a ~10 nm intrinsic Si buffer layer 80 is deposited to avoid problems of selectivity connected to SiGe growth. Then, a SiGe:C first intrinsic base layer 82 is formed which consists of 10 nm to 40 nm, in the embodiment ∼20 nm intrinsic (undoped) SiGe:C, followed by doped base layer 84 of 2nm to 10 nm, in the embodiment ∼5 nm SiGe:C doped with boron, around ~5E19 cm-3, then a second intrinsic SiGe:C layer 86 also 10 nm to 40 nm. These undoped intrinsic SiGe:C layers 82, 86 contain the boron diffusion within the SiGe:C during the thermal steps in the process. On top, a 10 to 100 nm, in the embodiment25-50nm 10¹⁷ to 10¹⁹, in the embodiment 10¹⁸ cm⁻³ boron doped silicon layer 88 is grown, which is usually referred to as emitter cap 88 because it holds the n-type outdiffusion of the emitter that is deposited later.

Note that the base layer 22 is deposited in a crystalline form on the collector region 6 of the silicon substrate, but forms a polysilicon base region 24 on the STI structures 4.

Wide spacers 26, in the example shown of tetraethyl orthosilicate (TEOS) are defined as is shown in Figure 4. In the conventional process the spacer consists of a stack of ~10 nm TEOS, followed by ∼25 nm silicon nitride used for end-point detection and ∼200 nm TEOS. In this case, the silicon nitride liner below the spacer is not needed because the spacer is completely sacrificial, so the spacer 26 is formed simply of TEOS.

After deposition of the TEOS, a spacer etch is performed that stops before reaching the base layer 22, by using a timed etch. There is no need for endpoint detection in the etch procedure, which again improves manufacturability. This results in the arrangement shown in Figure 4. The spacer profile at the bottom can be made almost straight because it depends on the step height, so it can be optimized with the thickness of polysilicon on top of the nitride.

Alternatively, the conventional process may be used to form the spacer, with the spacer formed of the stack of TEOS, silicon nitride and TEOS.

Next, any oxide that remains at this point on the base layer 22 (on the silicon emitter cap) is removed by wet etching before emitter deposition.

An emitter 28 is then formed. This may be done by conventional doped polysilicon deposition. Alternatively, monocrystalline epitaxial growth of silicon may be formed in an epi step.

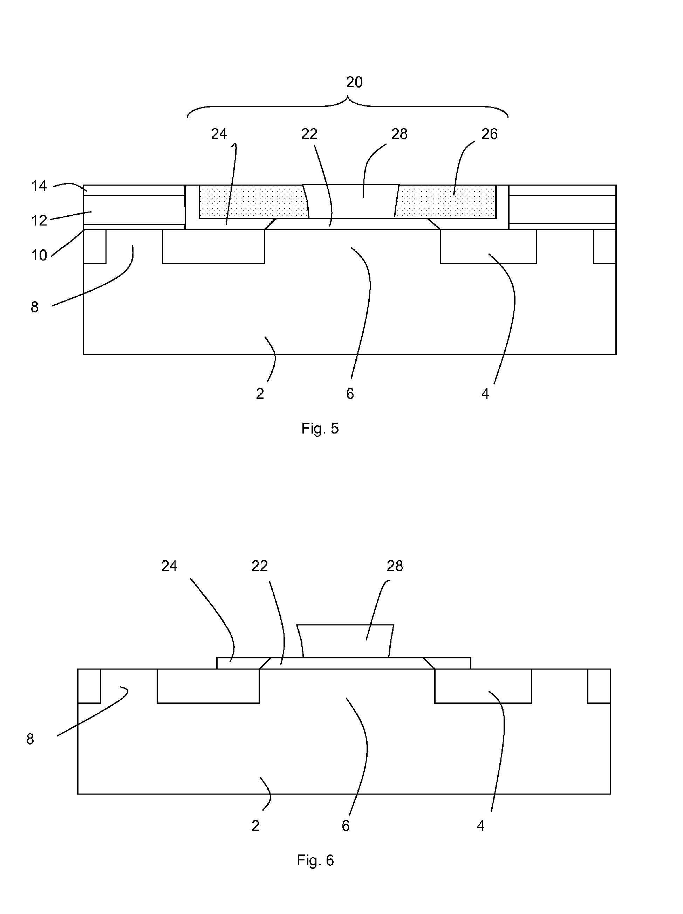

A chemical mechanical polishing step is then performed, which removes the top of the emitter 28 and the getter layer 16, stopping in the etch stop layer 14 of nitride, resulting in the stage shown in Figure 5.

Oxide spacers 26 are removed with a wet etch containing HF.

Then, a wet etch such as H₃PO₄ is used to remove the remaining silicon nitride etch stop layer 14. It is preferable that the thickness of silicon nitride that is left to be removed at this stage is thin. The more selective the CMP process is to silicon nitride, the thinner the etch stop layer 14 can be made.

In the conventional process of Figure 1, the nitride layer 114 above the gate layer 112 is needed to create a large enough step height to create a spacer 120 that separates the base connection 116 and the emitter 118. In approach of the invention the spacer 26 is made sacrificial, but in the conventional approach the spacer 120 is a vital part of the structure. For that reason it is more difficult in the conventional process to work with a very selective CMP process.

The rest of the processing uses existing CMOS base line processing steps. One of these is the step used in the CMOS processing to pattern the polysilicon gate of CMOS transistor 92. This step is used to remove the poly gate structure 12,10 in the bipolar transistor 90, together with any semiconductor part of the layer 124 on the sidewalls of the gate structure 12,10 that is grown at the sides of the poly gate. The resulting stage is shown in Figure 6.

CMOS spacers 30 (Figure 7) are formed using conventional CMOS proessing. The spacers 30 are formed to cover the edge of poly base region 24 as well as the edges of the emitter 28.

The remaining process can be simple conventional CMOS processing.

In particular, collector contact 32 is made to the substrate to connect to the collector contact region 8 and through substrate 2 under STI region 4 to buried collector 6. A base contact 34 is made to base contact region 24.

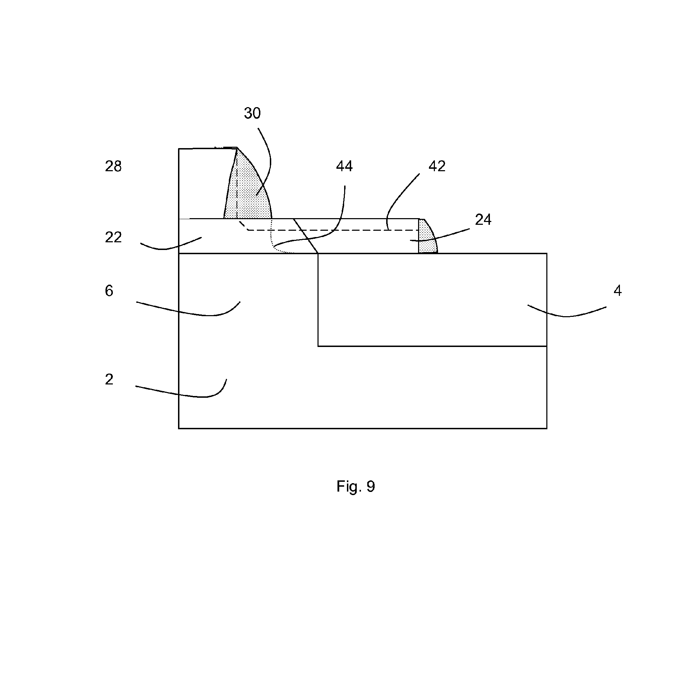

In an optional embodiment, the steps used to form low doped drain extensions that form part of the CMOS processing of CMOS transistor 92 are not just used in the CMOS devices 92 but are also used in the bipolar device 90. These steps take place before the formation of CMOS spacer 30, so the resulting extension doping 42 extends under the CMOS spacer 30 in the bipolar transistor as illustrated in Figure 9 by the dashed line.

The part of the base resistance of a bipolar transistor underneath the spacer 30 is usually referred to as the link resistance. It is highly desirable to reduce this link resistance because it is one of the bottlenecks in reducing further the base resistance and together with that, the minimum noise figure NFmin.

In a conventional BiCMOS process however, dedicated spacers are used, so providing a local extra doping concentration directly below the spacer is not trivial. However, in this optional embodiment, the drain extension doping 42 provides additional doping in the required area with no additional steps, so at no additional cost at all.

In this embodiment, the implant for the extension doping used in the example is a so-called halo implant, a p-type implant that comes together with a n-type. The halo is used to reduce the well-known short-channel effect. However, different processes may use different doping concepts.

For the sake of simplicity, the p-type boron in the grown SiGe:C base 22 layer is not shown in Figure 9. This p-type boron is connected extrinsically via the extrinsic base implant.

After the formation of CMOS spacers 30 p-type drain extension implantations 44 (see Fig. 9) are performed that at the same time dope the polysilicon gate in the CMOS devices. The p-type implantations that are used for the PMOS, are used again to make the extrinsic base. These implantations should not be done in NMOS regions, nor the emitter region of the bipolar, so a single mask is used to cover emitter 28 as well as the collector contact region 8 during this step. The mask also is used to cover any NMOS transistors so this step also does not require an additional mask. A relatively high doping concentration is used.

The rest of the processing is baseline CMOS processing and forms no additional process issues or features in this new low-cost bipolar architecture.

Thus, the described low-cost HBT manufacture further reduces process complexity and manufacturability

The integration of CMOS baseline process steps is further increased, i.e. CMOS spacers are used to define the extrinsic base implantation, providing at the same time the needed electrical isolation.

Base resistance may be improved with respect to the conventional process. This is beneficial for important figures of merit like maximum oscillation frequency fmax and minimum noise figures NFmin.

The option to use the lowly doped drain implantations of the CMOS process to provide a local extra doping of the bipolar base-link is a feature that may deliver an additional reduction of the base resistance.

The process forms the bipolar first and then the CMOS, which makes it truly CMOS compatible: none of the CMOS parameters are compromised, the bipolar device is processed before the MOS devices

It will be apparent to the skilled person that a number of modifications may be made to the process described above.

Firstly, in an alternative embodiment, the mask used to form base window 20 may be simply the same mask as used to form the collector region 6, which will of course require the window 20 and collector region to be aligned but will save one mask.

Secondly, the invention may also be used in a different modification conventional process as illustrated in Figure 1.

The gate stack may be any stack of layers suitable for forming the gate of a CMOS device.

## Claims

1. A method of manufacturing a bipolar transistor (90) and a CMOS transistor (92) on a semiconductor substrate (2), wherein forming the bipolar transistor (90) comprises:
forming a buried collector (6) doped to a first conductivity type in a substrate (2);
forming a gate stack (10) on the substrate (2);
patterning the gate stack (10) to form a base window (20) exposing the buried collector (6);
forming a base layer (22,24) on the base and the side walls of the base window (20) to form a base region (22) doped with a second conductivity type opposite to the first conductivity type;
forming a sacrificial spacer (26) in the base window (20) leaving the base region (22) in the base window (20) exposed; and
depositing an emitter (28) in the base window (20) in contact with exposed base region (22) in the base window (20); and
removing the sacrificial spacer (26) and the remaining gate stack (10) leaving the emitter (28) over base region (22); and
forming oxide spacers (30) on the sidewalls of the emitter (28).

2. A method according to claim 1 further comprising forming a low doped region after the step of removing the sacrificial spacer (26), and before the step of forming oxide spacers (30),
wherein the step of forming a low doped region forms a doped region in the base layer (22,24) except under the emitter (28) to enhance the conduction in the base layer (22,24).

3. A method according to claim 2, wherein the step of forming a low doped region also includes forming a low doped drain region in the CMOS transistor (92).

4. A method according to any preceding claim wherein the step of patterning and etching away the gate stack (10) to form the base window patterns the base window (20) to overlap both the buried collector (6) and shallow trench isolation regions (4) in the substrate (2) around the buried collector (6); and
the step of forming a base layer includes depositing a layer in the base window (20) to form a crystalline base region (22) above the buried collector (6) and a polycrystalline base connection region (24) above the shallow trench isolation regions (4) and on the sidewalls of the base window (20).

5. A method according to any of claims 1 to 3 wherein the step of patterning and etching away the gate stack (10) to form the base window patterns the base window (20) to be aligned to the buried collector (6); and
the step of forming a base layer includes depositing a layer in the base window (20) to form a crystalline base region (22) above the buried collector (6) and a polycrystalline base connection region (24) on the sidewalls of the base window (20).

6. A method according to any preceding claim, wherein forming the CMOS transistor (92) includes forming a gate stack of the CMOS transistor during the step of forming the gate stack (10) on a semiconductor substrate and patterning the gate stack (10) of the CMOS transistor to form the gate of the CMOS transistor during the step of removing the sacrificial spacer (26) and the remaining gate stack (10).

7. A method according to any preceding claim wherein the step of forming oxide spacers on the sidewalls of the emitter (28) forms the oxide spacers also on the CMOS transistor (92).

8. A method according to any preceding claim wherein the gate stack (10) includes a polysilicon gate layer (12) and an insulating layer (14) over the polysilicon gate layer (12).

9. A method according to claim 8, wherein the gate stack (10) includes an etch stop layer (14) as the insulating layer (14) above the polysilicon layer (12).

10. A method according to claim 9, wherein the step of forming a sacrificial spacer (26) includes depositing tetraethylorthosilicate, TEOS, and carrying out a chemical mechanical polishing step back to the etch stop layer (14) to etch back the TEOS to form the spacer (26).

11. A method according to any preceding claim wherein the step of forming a base layer (22, 24) forms a layer of Si and/or SiGe.

12. A method according to claim 11 wherein the step of forming the base layer (22, 24) includes forming a base stack including a Si layer (80), and a doped SiGe layer (84).

13. A method according to claim 12 wherein the step of forming the base stack includes forming the Si layer (80), forming a first intrinsic SiGe layer (82), forming the doped SiGe layer (84), and forming a second intrinsic SiGe layer (86).

14. A semiconductor device comprising a CMOS transistor (92) and a bipolar transistor (90) in a substrate (2), wherein the bipolar transistor comprises:
a shallow trench isolation structure (4) defining a collector region (6) in the substrate;
a base including a doped crystalline base layer (22) directly on the collector region (6) and a polycrystalline base layer (24) directly on the shallow trench isolation structure (4);
an emitter (28) on the base layer (22); and
spacers (30) on the sidewalls of the emitter (28) and the polycrystalline base layer (24);
further comprising a doped extension region extending from the polycrystalline base layer (24) under a spacer (30) on the sidewall of the emitter (28) into the doped crystalline base layer (22).
